# EUROPÄISCHE PATENTSCHRIFT

(11) **EP 0 986 291 B1**
(45) Veröffentlichungstag und Bekanntmachung des Hinweises auf die Patenterteilung: **21.06.2006**
(21) Anmeldenummer: 98117146.5
(22) Anmeldetag: 10.09.1998
(51) Int. Cl.: H05K 5/03

(54) **Platte zu einer Installationseinheit**
Plate for installation unit
Plaque pour une unité d'installation

(43) Veröffentlichungstag der Anmeldung: 15.03.2000
(73) Patentinhaber: Siemens Schweiz AG, 8047 Zürich (CH)
(72) Erfinder: Radatti, Giuseppe, 8634 Hombrechtikon (CH)
(74) Vertreter: Weise, Wolfgang

(56) Entgegenhaltungen:
- EP-A- 0 722 208
- US-A- 4 520 976

## Beschreibung

Die Erfindung bezieht sich auf eine Platte gemäss dem Oberbegriff des Anspruchs 1.

Solche Platten eignen sich beispielsweise zur Verwendung als Frontplatte oder als Abdeckplatte zu einer elektrischen oder elektronischen Installationseinheit, wobei eine derartige Platte in einen Trägerrahmen einbaubar und zur Aufnahme von Bedienungselementen wie beispielsweise Anzeigeeinheiten, Schalter oder Kartenleser vorbereitet ist. Solche Platten eignen sich insbesondere zur Verwendung in Gebäudeinstallationseinheiten.

Es ist ein Einrichtung zum Befestigen einer Frontplatten bekannt (EP 0 665 707 A1), bei der eine Schraubverbindung zum Befestigen der Frontplatte an seitlichen Profilschienen vorgeschlagen wird.

Es ist auch bekannt (WO 97/49270), eine Frontplatte zentrierbar mittels Schraubverbindugen zu befestigen, indem in einem Rahmen Zentrierleisten vorgesehen werden.

Eine Platte der im Anspruch 1 genannten Art ist aus EP 0 722 208 A2 bekannt. Die Platte weist vier federelastische Rastarme auf, die paarweise an zwei gegenüberliedenden Randseiten der Platte angeordnet sind.

Bekannte Frontplatten oder Trägerplatten benötigen jedoch stets einen gewissen Rahmen, der in seiner Geometrie und Ausgestaltung genau auf die dazugehörige Platte abgestimmt ist, wobei die zulässigen Toleranzen für die Masse der Platte relativ klein sind.

Der Erfindung liegt die Aufgabe zugrunde, eine selbstzentrierbare Platte anzugeben, welche in Rahmen mit unterschiedlicher Ausgestaltung und mit unterschiedlichen Masstoleranzen einfach und zuverlässig einbaubar ist.

Die genannte Aufgabe wird erfindungsgemäss durch die Merkmale des Anspruchs 1 gelöst. Vorteilhafte Ausgestaltungen ergeben sich aus den abhängigen Ansprüchen.

Nachfolgend werden Ausführungsbeispiele der Erfindung anhand der Zeichnung näher erläutert.

Es zeigen:
- Fig. 1: ein Ausführungsbeispiel einer in einem Rahmen einbaubaren Platte für einen Kartenleser,
- Fig. 2: ein Ausfürungsbeispiel der Platte für eine Anzeigeeinheit, und
- Fig. 3: das Prinzip der Selbszentrierung der Platte in einem Rahmen.

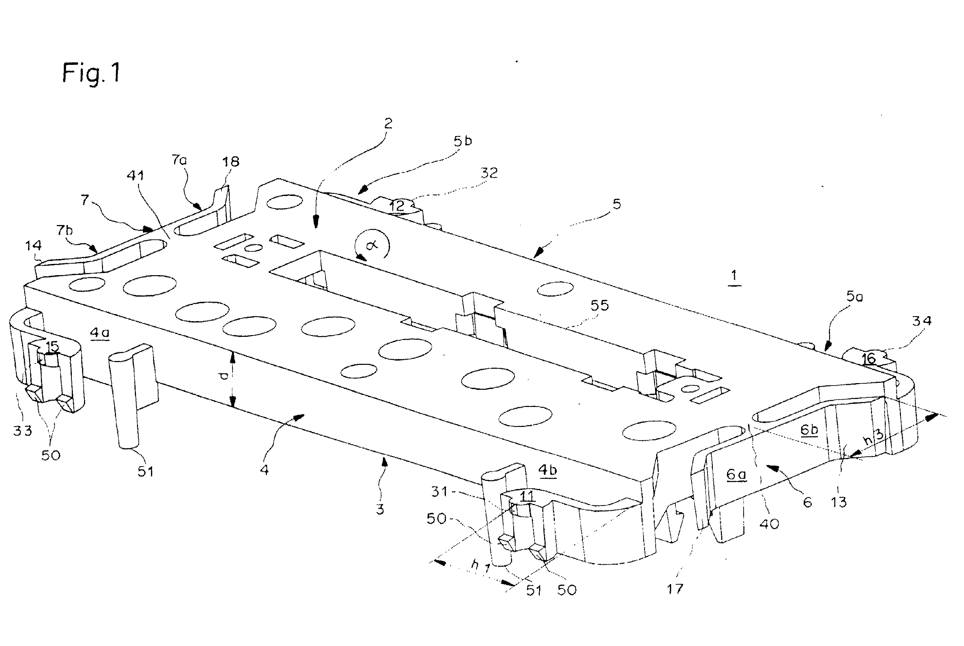

In der Fig. 1 bedeutet 1 eine Platte, welche vereinfacht betrachtet die Form eines Rechtkants aufweist, dessen sechsseitige Oberfläche durch zwei im Abstand der Plattendicke d einander gegenüber liegende Deckseiten 2 und 3 sowie eine erste Randseite 4, eine zweite Randseite 5, eine dritte Randseite 6 und eine vierte Randseite 7 aufweist, wobei die beiden Randseiten 4 und 5 und auch die beiden Randseiten 6 und 7 jeweils einander gegenüber liegen.

Die vier Randseiten 4, 5, 6 und 7 sind nicht als ebene Flächen ausgeführt, denn an der Platte 1 sind an den vier Randseiten 4, 5, 6 und 7 - wie unten beschrieben wird - Funktionsteile ausgebildet.

Zur Vereinfachung der Beschreibung werden die vier Randseiten 4, 5, 6 und 7 in einem Umlaufsinn α, entsprechend dem Gegenuhrzeigersinn bezogen auf die Deckseite 2, hälftig unterteilt und bezeichnet. Im besagten Umlaufsinn α folgen sich somit auf dem Rand der Platte 1 eine erste Seitenhälfte 4a und die zweite Seitenhälfte 4b der ersten Randseite 4, eine erste Seitenhälfte 6a und die zweite Seitenhälfte 6b der dritten Randseite 6, eine erste Seitenhälfte 5a und die zweite Seitenhälfte 5b der zweiten Randseite 5 und schliesslich eine erste Seitenhälfte 7a und die zweite Seitenhälfte 7b der vierten Randseite 7.

An der einteiligen Platte 1 sind wenigstens vier federnde Mittel ausgebildet, durch welche die Platte 1 in einem im wesentlichen rechteckförmigen Ausschnitt eines in der Fig. 1 nicht gezeichneten Rahmens selbsttätig zentrierbar und klemmbar sind.

Ein erstes federndes Mittel ist ein erstes Federelement 11, das in der zweiten Seitenhälfte 4b der ersten Randseite 4 angeordnet ist. Ein zweites federndes Mittel ist ein zweites Federelement 12, das in der zweite Seitenhälfte 5b der zweiten Randseite 5 angeordnet ist. Ein drittes federndes Mittel ist ein drittes Federelement 13, das in der zweiten Seitenhälfte 6b der dritten Randseite 6 angeordnet ist. Ein viertes federndes Mittel ist schliesslich ein viertes Federelement 14, das in der zweiten Seitenhälfte 7b der vierten Randseite 7 angeordnet ist.

In einer Ausführungsvariante der Platte 1 sind vier weitere federnde Mittel - also insgesamt acht federnde Mittel - ausgebildet, durch welche die Platte 1 im Ausschnitt des Rahmens selbsttätig zentrierbar und klemmbar sind. Ein fünftes federndes Mittel ist ein fünftes Federelement 15, das in der ersten Seitenhälfte 4a der ersten Randseite 4 angeordnet ist. Ein sechstes federndes Mittel ist ein sechstes Federelement 16, das in der ersten Seitenhälfte 5a der zweiten Randseite 5 angeordnet ist. Ein siebtes federndes Mittel ist ein siebtes Federelement 17, das in der ersten Seitenhälfte 6a der dritten Randseite 6 angeordnet ist. Ein achtes federndes Mittel ist schliesslich ein achtes Federelement 18, das in der ersten Seitenhälfte 7a der vierten Randseite 7 angeordnet ist.

In einer vorteilhaften Ausführung der Platte 1 ist das Federelement 11, 12, 15 oder 16 im wesentlichen aus einem Federarm verwirklicht, an dem ein Auflager 31 bzw. 32 bzw. 33 bzw. 34 zur Abstützung am Rahmen ausgebildet ist. Mit Vorteil ist das Federelement 11, 12, 15 oder 16 derart ausgeführt und angeordnet, dass es in der entsprechenden Seitenhälfte 4b, 5b, 4a oder 5a in einem Bereich nahe bei der angrenzenden Randseite 6 bzw. 7 wirksam ist. Die besagte Ausführung des Federelementes 11, 12, 15 oder 16 ist insbesondere dann vorteilhaft, wenn die erforderliche Länge h1 des Ferderarms - wie im gezeichneten Beispiel - deutlich kleiner als die halbe Länge der entsprechenden Randseite 4 oder 5 ist.

In der vorteilhaften Ausführung der Platte 1 weisen die beiden auf einer gemeinsamen Randseite 6 bzw. 7 angeordneten Federelemente 13 und 17 bzw. 14 und 18 eine gemeinsame Ansatzzone 40 bzw. 41 des Federarmes auf. Die besagte Ausführung des Federelementes 13, 14, 17 oder 18 ist insbesondere dann vorteilhaft, wenn die erforderliche Länge h3 des Ferderarms - wie im gezeichneten Beispiel - etwa gleich gross wie die halbe Länge der entsprechenden Randseite 6 oder 7 ist.

Bei Bedarf sind an der Platte 1 zusätzliche Befestigungsmittel zur Befestigung der Platte 1 am Rahmen ausgebildet. In einer vorteilhaften Variante sind die zusätzlichen Befestigungsmittel als Nocken 50 verwirklicht, welche am Federelement 11, 12, 15 bzw. 16 derart ausgebildet sind, dass die Platte beim Einlegen in den Rahmen durch Formschluss der Nocken 50 am Rahmen befestigbar ist.

Bei Bedarf sind an der Platte 1 auch Mittel 51 zur Begrenzung der maximalen Einbautiefe ausbildet, welche bei einem Einschieben der Platte 1 in den Rahmen als Anschlag an den Rahmen wirken.

Je nach Ausgestaltung eignet sich die einteilige Platte 1 zur Verwendung als Frontplatte, als Trägerplatte oder als Abdeckplatte zu einer elektrischen oder elektronischen Installationseinheit, wobei die Platte 1 in einen Rahmen einbaubar und zur Aufnahme von Bedienungselementen oder Einrichtungen wie beispielsweise Anzeigeeinheiten, Schalter oder Kartenleser geeignet ist. Der Rahmen kann auch Teil einer Dose oder eines Gehäuses sein. Insbesondere ist die Platte 1 auch in einen Rahmen eines in einer Gebäudewand eingebauten Gehäuses bzw. einer in einer Gebäudewand eingebauten Dose selbstzentrierend einbaubar, wobei die Masse des Rahmens einen relativ grossen Toleranzbereich umfassen dürfen. Insbesondere ist die Platte 1 auch dann einsetzbar, wenn die Ausgestaltung des Rahmens in gewissen Varianten ausgeführt ist, wie dies beispielsweise dann der Fall ist, wenn der Rahmen bzw. das Gehäuse oder die Dose von verschiedenen Anbietern unterschiedlich ausgestaltet auf dem Markt angeboten werden.

Die beispielhafte Ausführung der Platte 1 in der Fig. 1 weist einen Ausschnitt 55 zum Einbauen eines Kartenlesers auf. Mit dem in der Zeichnung nicht dargestellten Kartenleser sind Datenträger wie beispielsweise Magnetkarten oder Chipkarten lesbar.

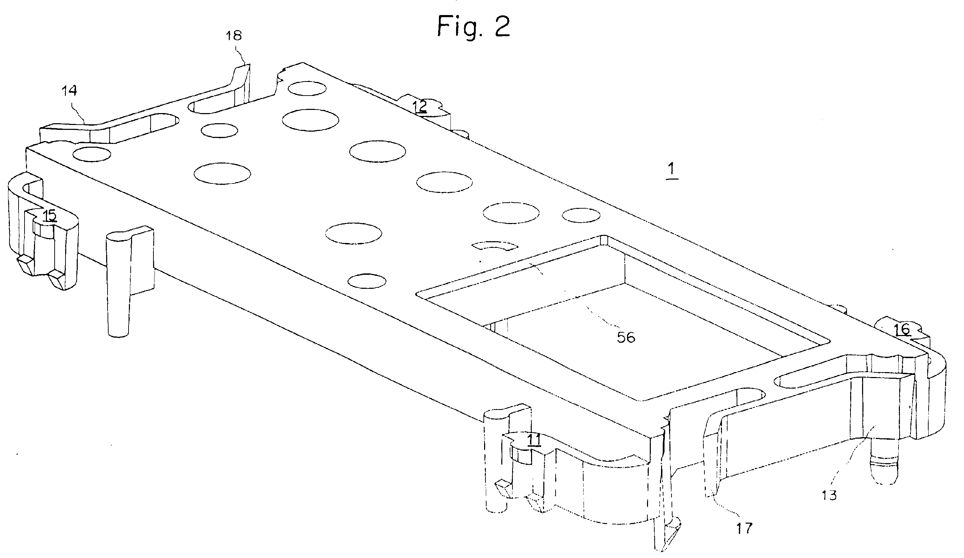

Eine weitere beispielhafte Ausführung der Platte 1 ist in der Fig. 2 dargestellt. Ein Ausschnitt 56 ist zur Aufnahme einer Anzeigeeinheit, beispielsweise einer Flüssigkristallanzeigeeinheit ausgeführt. Gleiche Bezugszeichen in der Zeichnung bezeichnen gleichartige Teile oder Merkmale.

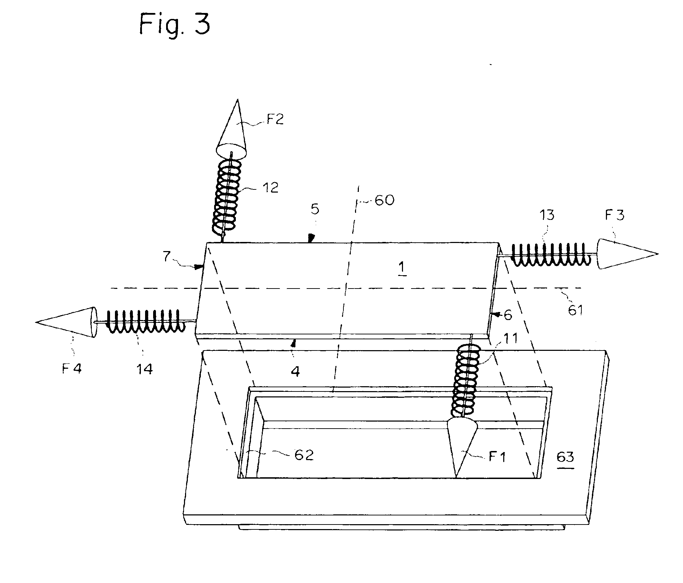

Zur Verdeutlichung der Wirkungsweise der Selbstzentrierung und Klemmen zeigt die Fig. 3 schematisch die Platte 1 mit den für die Selbstzentrierung notwendigen federnden Mitteln, nämlich mit dem ersten, mit der Federkraft F 1 spannbaren Federelement 11, dem zweiten, mit der Federkraft F2 spannbaren Federelement 12, dem dritten, mit der Federkraft F3 spannbaren Federelement 13 und dem vierten, mit der Federkraft F4 spannbaren Federelement 14.

Mit 60 ist eine erste Symmetrieachse bezeichnet, welche durch die Mitte der ersten Randseite 4 und durch die Mitte der zweiten Randseite 5 verläuft. Eine zweite Symmetrieachse 61 verläuft durch die Mitte der dritten Randseite 6 und durch die Mitte der vierten Randseite 7.

Eine selbsttätige, symmetrische Ausrichtung der in einen rechteckförmigen Ausschnitt 62 eines Rahmens 63 eingeschobenen Platte 1 entlang der ersten Symmetrieachse 60 und zugleich entlang der zweiten Symmetrieachse 61 resultiert durch das Zusammenwirken von vier Momenten, welche durch die im Ausschnitt 62 des Rahmens 63 aufliegenden vier Federelemente 11, 12, 13 und 14 generiert werden.

Um mit geringen Federkräften eine zuverlässige Selbstzentrierung der Platte 1 im Ausschnitt 62 zu erreichen, sind das erste Federelement 11 und das zweite Federelemente 12 derart anzuordnen, dass die Wirkungslinien der ersten Federkraft F1 und der zweiten Federkraft F2 möglichst weit entfernt von der ersten Symmetrieachse 60 verlaufen, während das dritte Federelement 13 und das vierte Federelemente 14 so anzuordnen sind, dass die Wirkungslinien der ersten Federkraft F1 und der zweiten Federkraft F2 möglichst weit entfernt von der zweiten Symmetrieachse 61 verlaufen, wobei die erforderlichen Federkräfte F1, F2, F3 und F4 aufgrund der gewählten Abstände von den Symmetrieachsen 60 bzw. 61 in bekannter Art aufeinander abstimmbar sind.

Besonders kostengünstig ist die einteilige Platte 1 in einem Spritzgussverfahren aus Kunststoff herstellbar, wobei der verwendete Kunststoff insbesondere an die bezüglich Festigkeit der Platte 1 gesetzten Anforderungen und an die erforderliche Elastizität der an der Platte 1 ausgeführten federnden Mittel 11 bis 18 anpassbar ist. Beispielhaft seien hier mit Bayblend®, Lexan®, Technyl® und Ultramid® eine Gruppe von Werkstoffen genannt, welche grundsätzlich zur Ausbildung der Platte 1 geeignet sind, wobei es selbstverständlich ist, dass auf dem Markt noch zahlreiche andere geeignete Werkstoffe angeboten werden.

## Patentansprüche

1. Platte zum Einbauen in einen im wesentlichen rechteckförmigen Ausschnitt (62) eines Rahmens (63),
mit wenigstens vier an der Platte (1) ausgebildeten Federelementen (11, 12, 13, 14),
**dadurch gekennzeichnet,**
**dass** mindestens je ein Federelement (11; 12; 13; 14) auf je einer dem Rahmen (63) zugewandten Plattenseite (4; 5; 6; 7) angeordnet ist, und
**dass** die Federelemente (11; 12; 13; 14) derart angeordnet sind, dass die Wirkungslinie der Federkraft (F1; F2; F3, F4) jedes der vier Federelemente (11; 12; 13; 14) gegen den Rahmen (63) hin, bezogen auf die Symmetrieachse (60; 61) der entsprechenden Plattenseite (4; 5; 6; 7), auf der das Federelement (11; 12; 13; 14) ausgebildet ist, exzentrisch wirksam wird, so
**dass** die Platte (1) im Ausschnitt (62) selbsttätig zentrierbar und klemmbar ist.

2. Platte nach Anspruch 1, **dadurch gekennzeichnet, dass** auf jeder Plattenseite (4; 5; 6; 7) zwei Federelemente (11, 15 bzw. 12, 16 bzw. 13, 17 bzw. 14, 18) angeordnet sind.

3. Platte nach Anspruch 1, **dadurch gekennzeichnet, dass** die Platte (1) acht Federelemente (11; 12; 13; 14; 15; 16; 17; 18) aufweist,
wobei je zwei Federelemente (11, 15 bzw. 13, 17 bzw. 12, 16 bzw. 14, 18) auf je einer dem Rahmen (63) zugewandten Plattenseite (4 bzw. 6 bzw. 5 bzw. 7) angeordnet sind.

4. Platte nach einem vorangehenden Anspruch, **dadurch gekennzeichnet, dass** an der Platte (1) weitere Befestigungsmittel (50) ausgebildet sind, welche beim Einlegen der Platte (1) in den Rahmen (63) derart einschnappbar sind, dass die Platte (1) am Rahmen (63) durch Formschluss befestigbar ist.

5. Platte nach einem vorangehenden Anspruch, **dadurch gekennzeichnet, dass** ein Federelement (11; 12; 15; 16) im wesentlichen aus einem Federarm verwirklicht ist, an dem ein Auflager (31; 32; 33; 34) zur Abstützung am Rahmen (63) ausgebildet ist.

6. Platte nach einem vorangehenden Anspruch, **dadurch gekennzeichnet dass** die Federarme von zwei zu einer gemeinsamen Plattenseite (6; 7) gehörenden Federelementen (13, 17 bzw. 14, 18) eine gemeinsame Ansatzzone (40 bzw. 41) an der Platte (1) aufweisen.

7. Platte nach Anspruch 4, **dadurch gekennzeichnet, dass** die Befestigungsmittel, (50) an den Federelementen (11, 12, 15, 16) ausgebildet sind.

8. Platte nach einem vorangehenden Anspruch, **dadurch gekennzeichnet, dass** Mittel (51) zur Begrenzung der Einbautiefe an der Platte (1) ausgebildet sind.

9. Platte nach einem vorangehenden Anspruch, **dadurch gekennzeichnet, dass** die Platte (1) aus einem Kunststoff und einteilig aufgebaut ist.

## Claims

1. Plate for installing in an essentially rectangular cutout (62) of a frame (63),
having at least four spring elements (11, 12, 13, 14) formed on the plate (1),
**characterized**
**in that** at least in each case one spring element (11; 12; 13; 14) is arranged on a respective plate side (4; 5; 6; 7) directed towards the frame (63), and
**in that** the spring elements (11; 12; 13; 14) are arranged such that the line of action of the spring force (F1; F2; F3; F4) of each of the four spring elements (11; 12; 13; 14) is active eccentrically in the direction of the frame (63), in relation to the axis of symmetry (60; 61) of the corresponding plate side (4; 5; 6; 7) on which the spring element (11; 12; 13; 14) is formed, with the result that the plate (1) can be automatically centred and clamped in the cutout (62).

2. Plate according to Claim 1, **characterized in that** two spring elements (11, 15 and 12, 16 and 13, 17 and 14, 18) are arranged on each plate side (4; 5; 6; 7).

3. Plate according to Claim 1, **characterized in that** the plate (1) has eight spring elements (11; 12; 13; 14; 15; 16; 17; 18), in each case two spring elements (11, 15 and 13, 17 and 12, 16 and 14, 18) being arranged on a respective plate side (4, 6, 5, 7) directed towards the frame (63) .

4. Plate according to a preceding claim, **characterized in that** the plate (1) has formed on it further fastening means (50) which, when the plate (1) is inserted into the frame (63), can be snapped in such that the plate (1) can be fastened on the frame (63) by a form fit.

5. Plate according to a preceding claim, **characterized in that** a spring element (11; 12; 15; 16) is made essentially from a spring arm on which is formed a bearing means (31; 32; 33; 34) for support on the frame (63).

6. Plate according to a preceding claim, **characterized in that** the spring arms of two spring elements (13, 17 and 14, 18) belonging to a common plate side (6; 7) have a common attachment zone (40, 41, respectively) on the plate (1).

7. Plate according to Claim 4, **characterized in that** the fastening means (50) are formed on the spring elements (11, 12, 15, 16).

8. Plate according to a preceding claim, **characterized in that** means (51) for limiting the installation depth are formed on the plate (1).

9. Plate according to a preceding claim, **characterized in that** the plate (1) is made of a plastic and is constructed in one piece.

## Revendications

1. Plaque destinée à être montée dans une découpe sensiblement rectangulaire (62) d'un châssis (63),
ayant au moins quatre éléments élastiques (11, 12, 13, 14) formés sur la plaque (1),
**caractérisée en ce que**
au moins respectivement un élément élastique (11 ; 12 ; 13 ; 14) est disposé sur respectivement l'une des faces de la plaque (4 ; 5 ; 6 ; 7) qui est tournée vers le châssis (63) et
**en ce que** les éléments élastiques (11 ; 12 ; 13 ; 14) sont disposés de façon telle, que la ligne d'action de la force élastique (F1 ; F2 ; F3, F4) de chacun des quatre éléments élastiques (11, 12, 13, 14) agit de façon excentrée en direction du châssis (63), par rapport à l'axe de symétrie (60 ; 61) de la face correspondante de la plaque (4; 5 ; 6 ; 7) sur laquelle l'élément élastique (11 ; 12; 13 ; 14) est formé, de sorte que la plaque (1) puisse se centrer et se caler automatiquement dans la découpe.

2. Plaque selon la revendication 1, **caractérisée en ce que** deux éléments élastiques (11, 15 ou 12, 16 ou 13, 17 ou 14, 18) sont disposés sur chaque face de la plaque (4 ; 5 ; 6 ; 7).

3. Plaque selon la revendication 1, **caractérisée en ce que** la plaque (1) comporte huit éléments élastiques (11; 12 ; 13 ; 14 ; 15 ; 16 ; 17 ; 18),
respectivement deux éléments élastiques (11, 15 ou 12, 16 ou 13, 17 ou 14, 18) étant disposés sur respectivement une face de la plaque (4 ou 6 ou 5 ou 7) qui est dirigée vers le châssis (63).

4. Plaque selon l'une quelconque des revendications précédentes, **caractérisée en ce que** des moyens de fixation supplémentaires (50), qui lors du placement de la plaque (1) dans le châssis (63) sont encliquetables de façon à permettre de fixer la plaque (1) par complémentarité de forme sur le châssis (63), sont formés sur la plaque (1).

5. Plaque selon l'une quelconque des revendications précédentes, **caractérisée en ce qu'**un élément élastique (11 ; 12 ; 15 ; 16) est sensiblement conçu en tant qu'un bras élastique, sur lequel est formé un appui (31 ; 32; 33 ; 34) pour le soutien sur le châssis (63).

6. Plaque selon l'une quelconque des revendications précédentes, **caractérisée en ce que** les bras élastiques de deux éléments élastiques (13, 17 ou 14, 18) faisant partie d'une face de plaque commune (6 ; 7) comportent une zone de jonction commune (40 ou 41) sur la plaque (1).

7. Plaque selon la revendication 4, **caractérisée en ce que** les moyens de fixation (50) sont formés sur les éléments élastiques (11, 12, 15, 16).

8. Plaque selon l'une quelconque des revendications précédentes, **caractérisée en ce que** des moyens (51) de délimitation de la profondeur de montage sont formés sur la plaque (1).

9. Plaque selon l'une quelconque des revendications précédentes, **caractérisée en ce que** la plaque (1) est conçue en une matière plastique et en monobloc.
